Europäisches Patentamt

European Patent Office

Office européen des brevets

(19)

(11) **EP 1 270 505 A2**

(12) **EUROPEAN PATENT APPLICATION**

(43) Date of publication:
02.01.2003 Bulletin 2003/01

(51) Int Cl.⁷: **B81B 3/00**

(21) Application number: 02014541.3

(22) Date of filing: 01.07.2002

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(30) Priority: 30.06.2001 KR 2001038806

(71) Applicant: **SAMSUNG ELECTRONICS CO., LTD.**
**Suwon-City, Kyungki-do (KR)**

(72) Inventors:
• **Cho, Jin-woo**
  **Bundang-gu, Seongnam-city, Kyungki-do (KR)**
• **Lee, Moon-chul**
  **Bundang-gu, Seongnam-city, Kyungki-do (KR)**
• **Lee, Eun-sung**
  **Jung-gu, Daejeon (KR)**

(74) Representative: **Grünecker, Kinkeldey,**
**Stockmair & Schwanhäusser Anwaltssozietät**
**Maximilianstrasse 58**
**80538 München (DE)**

(54) **Anti-stiction method and apparatus for drying wafer using centrifugal force**

(57) An anti-stiction method and apparatus for drying a wafer using a centrifugal force is provided. The anti-stiction method includes the steps of (a) removing a sacrificial layer stacked between the wafer and the micro structure, using an etching solution, (b) rinsing the etched micro structure and the etched wafer in a rinse solution for a predetermined time so that the etching solution between the micro structure and the wafer is replaced with the rinse solution, and (c) mounting the rinsed wafer in a mounting unit connected to a rotation axis and eliminating the rinse solution left between the wafer and the micro structure by the rotation of the axis. The wafer is mounted in the mounting unit in a vertical position so that the micro structure faces outwards from the rotation axis. Accordingly, a stiction phenomenon between the micro structure manufactured by a MEMS process and the wafer in a drying process can be prevented.

FIG. 3

EP 1 270 505 A2

**Description**

BACKGROUND OF THE INVENTION

1. Field of the Invention

The present invention relates to a method and apparatus for drying a wafer used to manufacture a semiconductor device and a device using a micro electro-mechanical system (MEMS), and more particularly, to an anti-stiction method and apparatus for drying a wafer using a centrifugal force.

2. Description of the Related Art

The most widely used radio frequency (RF) device among RF devices using micro electro-mechanical system (MEMS) techniques is an RF switch. This RF switch using MEMS techniques is generally used to sort signals in wireless communication systems using microwave or millimeter-wave, and in particular, in signal routing or impedance matching networks.

A micro structure allowing switching is embedded in an RF switch. A release process of removing a sacrificial layer and floating the micro structure stacked on the sacrificial layer on a substrate is necessarily required when this kind of micro structure is manufactured.

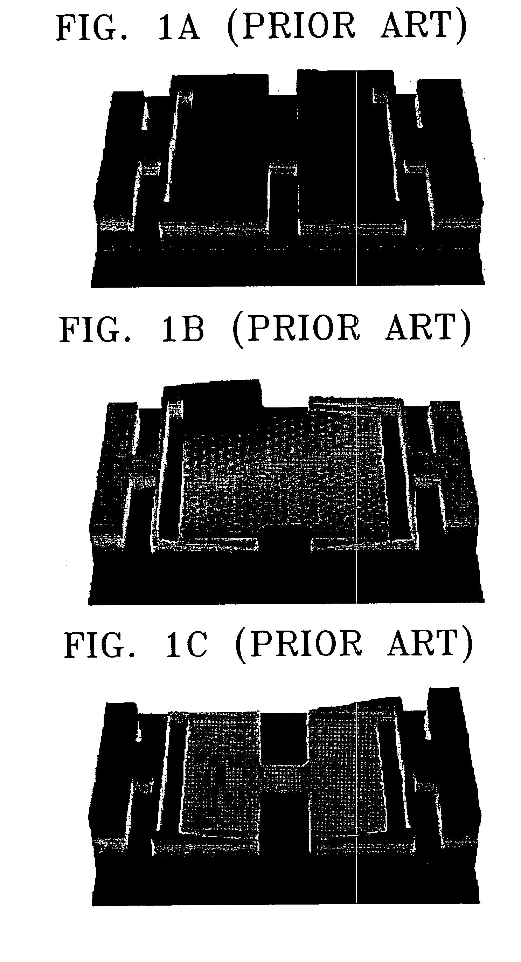

FIGS. 1A through 1C are photos illustrating various micro structures after sacrificial layers are removed through a release process. FIG. 1A illustrates a MEMS structure in which a stiction phenomenon does not occur, FIG. 1B illustrates a MEMS structure in which a partial stiction phenomenon occurs, and FIG. 1C illustrates a MEMS structure in which an overall stiction phenomenon occurs.

The release process may be a dry etching process or a wet etching process. In the dry etching process, a solid sacrificial layer is changed into a vapor state using a plasma and is then removed, thereby the stiction of the structure due to surface tension in the wet etching process to be described later can be prevented. However, considerable heat is generated in the dry etching process, and thus thermal deformation of the micro structure may occur.

Meanwhile, heat is not generated in the wet etching process, and thus the deformation of the micro structure due to heat can be prevented. However, stiction occurs between the substrate and the micro structure due to surface tension occurring in a process of drying a wafer after the sacrificial layer is removed. Thus, this stiction makes it difficult to manufacture fine RF switches, and causes frequent malfunctions of RF switches.

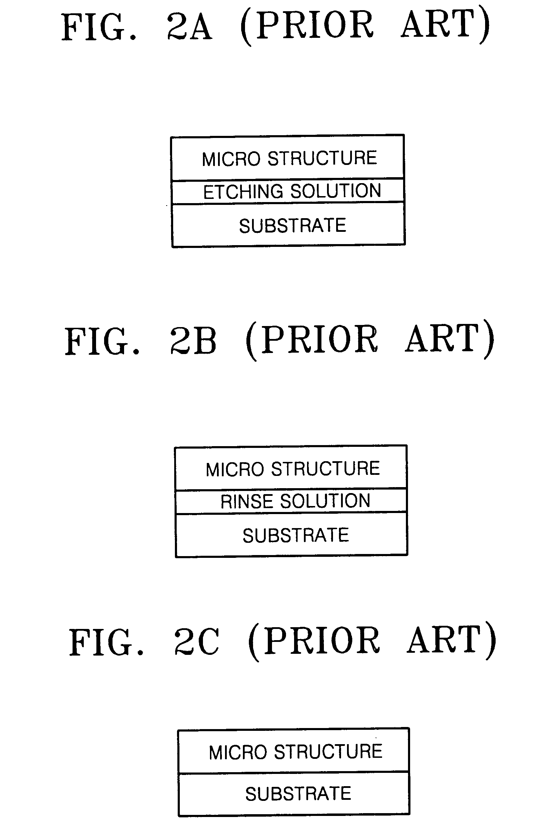

FIGS. 2A through 2C illustrate steps in which a stiction phenomenon occurs in the release process by wet etching and steps in which the micro structure is stuck as a rinse solution is evaporating in the process of drying a wafer.

After the sacrificial layer is removed in the wet etching process, a portion in which the sacrificial layer between the substrate and the micro structure manufactured by a MEMS technique is removed, is filled with an etching solution (see FIG. 2A). Next, if the micro structure filled with the etching solution is rinsed by a rinse solution, the etching solution is replaced with the rinse solution (see FIG. 2B). Next, if the micro structure filled with the rinse solution is dried, the amount of the rinse solution is reduced, and the micro structure moves toward the substrate by the surface tension of the rinse solution, the process is repeated, and the micro structure is stuck on the substrate (see FIG. 2C).

If the stiffness of the micro structure is increased so as to prevent the stiction phenomenon, an interval between the micro structure and the substrate can be maintained even though the rinse solution evaporates in the drying process. However, this requires a very large driving voltage so as to drive the RF switches.

In order to solve the problem, various methods in which partial wet etching processes are modified have been proposed. That is, in freeze-drying methods, the rinse solution is first frozen, sublimated and then removed. However, a variation in the volume of the rinse solution when the rinse solution is frozen causes the deformation of the micro structure, and thus it is difficult to manufacture a structure, such as an RF MEMS switch.

A supercritical drying method is disclosed in U.S Patent No. 6,067,728. In the supercritical drying method, a rinse solution is replaced with fluid carbon dioxide ($CO_2$) in a high pressure chamber and then the fluid $CO_2$ is removed at a critical pressure point of $CO_2$, and a micro structure in which a stiction phenomenon does not occur can be manufactured. However, since the supercritical drying method requires a high atmospheric pressure of about 72 atmosphere, a stability problem appears, and costly equipment is required. Thus, it is difficult to manufacture practical RF switches using the supercritical drying method.

As another method, in an isopropyl alcohol (IPA) boiling method, after a wafer is put in boiled IPA, heated and then taken out, the IPA evaporates quickly by keeping the wafer in the air or placing in an oven at a temperature of about 100 - 300 °C, thereby preventing the stiction of the structure. However, the amount of the IPA stuck to the wafer, whenever the wafer is taken out from the IPA, is different, and the distribution of IPA depends on the position on the wafer, and thus a nonuniform yield is obtained. Accordingly, it is difficult to achieve a uniform yield during the release process, and thus it is also difficult to manufacture practical RF switches using the IPA boiling method.

## SUMMARY OF THE INVENTION

To solve the above problems, it is an object of the present invention to provide an anti-stiction method and apparatus for drying a wafer using a centrifugal force, so as to prevent the stiction occurring when the wafer is dried after a sacrificial layer is removed in a wet etching process.

Accordingly, to achieve the above object, according to one aspect of the present invention, there is provided an anti-stiction method for drying a wafer and a micro structure formed on the wafer. The method includes the steps of (a) removing a sacrificial layer stacked between the wafer and the micro structure, using an etching solution, (b) rinsing the etched micro structure and the etched wafer in a rinse solution for a predetermined time so that the etching solution between the micro structure and the wafer is replaced with the rinse solution, and (c) mounting the rinsed wafer in a mounting unit connected to rotation axis and eliminating the rinse solution left between the wafer and the micro structure by rotations of the axis, wherein the wafer is mounted in the mounting unit in a vertical position so that the micro structure faces outwards from the rotation axis. Preferably, the rinse solution is deionized (DI) water or iso-propyl alcohol (IPA).

Preferably, the centrifugal force due to the rotation of the axis is at least the same as or greater than the surface tension between the micro structure and the wafer.

In order to achieve the above object, according to another aspect of the present invention, there is provided an anti-stiction apparatus for drying a wafer using a centrifugal force. The apparatus includes a plurality of mounting units for fixing a micro structure formed on the wafer, and a rotating means for driving a rotation axis connected to the mounting units at a predetermined rotation speed, wherein the wafer is mounted in a vertical position so that the micro structure faces outwards from the rotation axis.

Preferably, the apparatus further includes a container in which a rinse solution is contained, a cover for covering the upper portion of the container and in which a bearing for supporting the rotation axis is mounted, wherein a rinse solution inlet for filling the container with the rinse solution and a rinse solution outlet for exhausting the rinse solution from the container are formed in the sides of the container.

## BRIEF DESCRIPTION OF THE DRAWINGS

The above object and advantages of the present invention will become more apparent by describing in detail a preferred embodiment thereof with reference to the attached drawings in which:

FIGS. 1A through 1C are photos illustrating the stiction states of micro structures after a sacrificial layer is removed through a release process;

FIGS. 2A through 2C illustrate steps in which a stiction phenomenon occurs in the release process by wet etching;

FIG. 3 is a cross-sectional view of an anti-stiction wafer dryer using a centrifugal force according to a preferred embodiment of the present invention; and

FIG. 4 is a partial top view of FIG. 3, illustrating a micro structure mounted in one mounting unit.

## DETAILED DESCRIPTION OF THE INVENTION

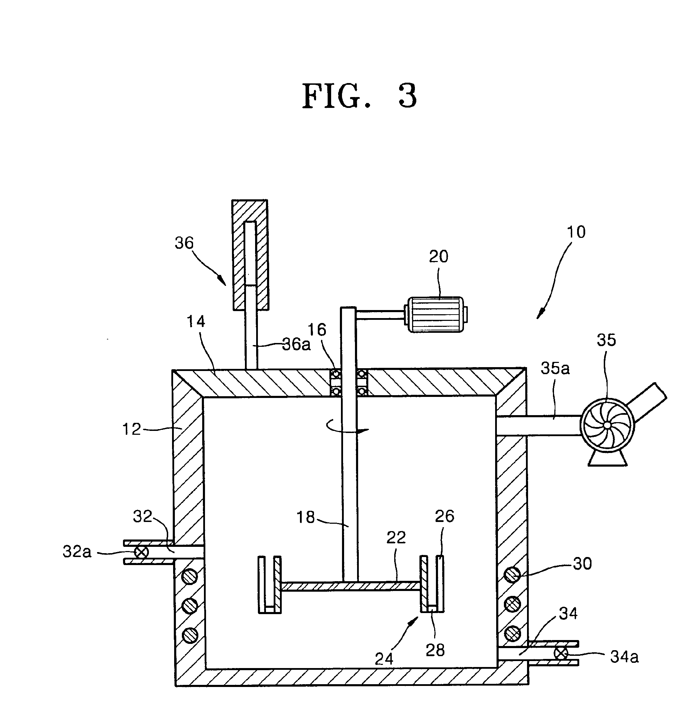

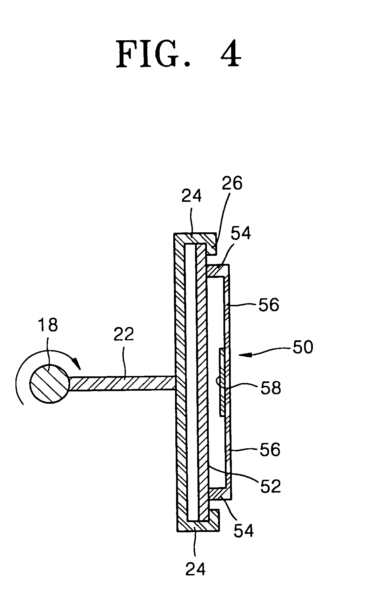

FIG. 3 is a cross-sectional view of an anti-stiction wafer dryer using a centrifugal force according to a preferred embodiment of the present invention, and FIG. 4 is a partial top view of FIG. 3, illustrating a micro structure mounted in one mounting unit. Even though FIGS. 3 and 4 present only one micro structure formed on one wafer, a plurality of micro structures can be formed on one wafer.

Referring to FIG. 3, a dryer 10 includes a container 12 to be filled with a rinse solution and a cover 14 for covering the upper portion of the container 12. A bearing 16 mounted in the center of the cover 14, and a rotation axis 18 is supported by the bearing 16. A connecting unit 22 is connected to the lower portion of the rotation axis 18, and a mounting unit 24 for mounting a micro structure 50 in which a micro electro-mechanical system (MEMS) switch is formed is connected to the connecting unit 22.

FIG. 4 is a partial top view illustrating one mounting unit 24 and the micro structure 50 mounted in the mounting unit 24. The micro structure 50 consists of a spring 56 supported by an anchor 54 on a wafer 52 and a membrane 58 supported by the spring 56.

With regard to the micro structure 50, the wafer 52 is mounted in the mounting unit 24 in a vertical position such that the membrane 58, which is the MEMS switch, is separated outwards from the rotation axis 18.

The mounting unit 24 includes a support jaw 26 formed at both sides so as to prevent the wafer 52 mounted in the mounting unit 24 from coming off during rotation, and a bottom part 28 formed so as to prevent the mounted wafer 52 from being dropped.

A rinse solution inlet 32 for injecting a rinse solution into the container 12 from outside, and a rinse solution outlet 34 for exhausting the rinse solution from the container 12 are set in the sides of the container 12. Valves 32a and 34a for opening and shutting off the flow of the rinse solution are placed in the pipes 32 and 34, respectively. A heating coil 30 for heating the rinse solution in the container 12 is embedded in the container 12.

The rotation axis 18 is rotated by a motor 20 at predetermined speed. An air outlet 35a is set in the upper right portion of the container 12, and a vacuum pump 35 is connected to the air outlet 35a. The cover 14 is connected to a rod 36a of a pneumatic cylinder 36, so that the cover 14 covers or uncovers the container 12.

The operation of the dryer having the above structure will be described with reference to FIGS. 3 and 4.

Referring to FIGS. 3 and 4, the cover 14 is moved upward from the container 12 using the pneumatic cylinder 36. Subsequently, the micro structure from which the sacrificial layer is removed using an etching solution is mounted in the mounting unit 24. In this case, the wafer 52 faces toward the rotation axis 18, and the membrane 58 faces toward the outside.

Subsequently, the valve 32a is opened in a state where the valve 34a is closed, and the rinse solution is injected into the container 12 through the rinse solution inlet 32 to a predetermined height. Deionized (DI) water or iso-propyl alcohol (IPA) is used as the rinse solution. If needed, the temperature of the rinse solution is increased to a predetermined value using the heating coil 30.

Subsequently, the cover 14 is moved down and covers the container 12 by operating the pneumatic cylinder 36. In this case, the mounting unit 24 connected to the rotation axis 18 moves downward, thereby the mounting unit 24 and the micro structure 50 are soaked in the rinse solution. The valve 34a of the rinse solution outlet 34 is opened after a predetermined time, thereby exhausting the rinse solution from the container 12. In order to avoid deformation of the structure 20 by air friction or pressure due to rotation, the container 12 may be maintained in a vacuum state by operating the vacuum pump 35 connected to the air outlet 35a.

When the rotation axis 18 rotates, a centrifugal force is applied to the micro structure 50, the micro structure 50 is fixed by the mounting unit 24, and due to rotation, most rinse solution is separated from the micro structure 50 and then removed. If the evaporation of the remaining solution begins, the surface tension between the micro structure 50 and the wafer 52 is applied to the micro structure 50 at first toward the rotation axis 24, and while the rotation takes place, the centrifugal force is simultaneously applied to the micro structure 50 in an opposite direction. Thus, an appropriate centrifugal force should be applied according to the stiffness and mass of the manufactured structure 50. When the rotation axis 18 rotates with angular velocity **w**, a centrifugal force $F_c$ applied to the structure having mass **m** and stiffness **k**, at a distance **r** from the center of the rotation axis 18, is expressed by Equation 1.

$$F_c = mrw^2 \qquad\qquad (1)$$

If surface tension $F_s$ is applied between the wafer 52 and the micro structure 50, the displacement **d** of the micro structure 50, regardless of mass, is expressed by Equation 2.

$$d = \frac{F_c - F_s}{k} \qquad\qquad (2)$$

Thus, the rotation axis 18 rotates with an angular velocity calculated according to the mass and stiffness of the micro structure 50, thereby preventing shortening of the distance between the micro structure 50 and the wafer 52, and evaporating the rinse solution between the micro structure 50 and the wafer 52. In this case, the direction of the centrifugal force should be opposite to the direction in which the micro structure 50 is stuck, and the sum of the surface tension and the centrifugal force should be within an elasticity limit of the micro structure 50. In case that the centrifugal force is greater than the surface tension, the direction of the centrifugal force becomes opposite to the direction in which the micro structure 50 is stuck, the distance between the micro structure 50 and the wafer 52 increases, thereby preventing the stiction of the micro structure 50. In case that the centrifugal force is equal to the surface tension, the micro structure 50 is maintained at a predetermined distance from the wafer 52, thereby preventing the stiction of the micro structure 50. In case that the centrifugal force is smaller than the surface tension, the micro structure is pulled out in the direction in which the micro structure 50 is stuck. However, the micro structure 50 has a restoring force (force caused by the stiffness of the structure), which is proportional to a deformation amount. Thus, if the surface tension is not greater than the sum of the restoring force of the micro structure 50 and the centrifugal force, the stiction can be prevented.

Experimental example

A micro structure was rinsed using deionized (DI) water at a room temperature for ten minutes after a sacrificial layer was removed from the micro structure when RF MEMS switches were manufactured, and then was soaked in iso-propyl alcohol (IPA) at room temperature for other five minutes. After that, a wafer was mounted in a mounting unit, placed 10 cm apart from the rotation axis, and then the wafer was dried by rotating the wafer at 2000 revolution per minute (RPM) for six minutes. RPM was calculated using Equation 3.

$$mass = 2.892e^{-9} \ kg,$$

$$Stiffness \ K = 1.18$$

$$= 11.8e^{-6} \ (centrifugal \ force \ for \ obtaining \ deformation \ of \ structure \ of \ 10 \ \mu m) \ N \ / \ m,$$

$$r = 0.1 \ m,$$

$$RPM = 1930 \cong 2000 \qquad (3)$$

Experimental results show that a stiction phenomenon does not occur after the wafer is dried.
As described above, according to the present invention, most rinse solution is removed in a fluid state by adjusting the angular velocity such that the centrifugal force is in an opposite direction to that of surface tension between a micro structure and a wafer in a drying process, and the deformation of the micro structure is maintained within an elasticity limit, thereby preventing the stiction phenomenon between the micro structure manufactured by a MEMS process and the wafer. The system does not require expensive equipments. In particular, works at a wafer level are possible, thereby enabling mass production.
While this invention has been particularly shown and described with reference to preferred embodiments thereof, it will be understood by those skilled in the art that various changes in form and details may be made therein without departing from the spirit and scope of the invention as defined by the appended claims.

**Claims**

1. An anti-stiction method for drying a wafer and a micro structure formed on the wafer, the method comprising the steps of:

   (a) removing a sacrificial layer stacked between the wafer and the micro structure, using an etching solution;
   (b) rinsing the etched micro structure and the etched wafer in a rinse solution for a predetermined time so that the etching solution between the micro structure and the wafer is replaced with the rinse solution; and
   (c) mounting the rinsed wafer in a mounting unit connected to a rotation axis and eliminating the rinse solution left between the wafer and the micro structure by rotations of the axis;

   wherein the wafer is mounted in the mounting unit in a vertical position so that the micro structure faces outwards from the rotation axis.

2. The method of claim 1, wherein the rinse solution is deionized (DI) water or iso-propyl alcohol (IPA).

3. The method of claim 1, wherein the centrifugal force due to the rotation of the axis is at least the same as or greater than the surface tension between the micro structure and the wafer.

4. An anti-stiction apparatus for drying a wafer using a centrifugal force, the apparatus comprising:

   a plurality of mounting units for fixing a micro structure formed on the wafer; and
   a rotating means for driving a rotation axis connected to the mounting units at a predetermined rotation speed;

   wherein the wafer is mounted in a vertical position so that the micro structure faces outwards from the rotation axis.

5. The apparatus of claim 4, further comprising:

a container in which a rinse solution is contained;
a cover for covering the upper portion of the container and in which a bearing for supporting the rotation axis is mounted;

wherein a rinse solution inlet for filling the container with the rinse solution and a rinse solution outlet for exhausting the rinse solution from the container are formed in the sides of the container.

6. The apparatus of claim 5, further comprising a heater for heating the container.

7. The apparatus of claim 5, further comprising means for moving the rotation axis upward and downward.

8. The apparatus of claim 7, wherein the moving means is a pneumatic cylinder for moving the cover up and down.

9. The apparatus of claim 5, wherein a vacuum pump for exhausting air in the container is further included.

## FIG. 1A (PRIOR ART)

## FIG. 1B (PRIOR ART)

## FIG. 1C (PRIOR ART)

# FIG. 2A (PRIOR ART)

| MICRO STRUCTURE |
|:---:|
| ETCHING SOLUTION |
| SUBSTRATE |

# FIG. 2B (PRIOR ART)

| MICRO STRUCTURE |
|:---:|
| RINSE SOLUTION |
| SUBSTRATE |

# FIG. 2C (PRIOR ART)

| MICRO STRUCTURE |
|:---:|
| SUBSTRATE |

# FIG. 3

# FIG. 4